# EUROPEAN PATENT APPLICATION

(11) **EP 4 358 146 A1**
(43) Date of publication of application: **24.04.2024**
(21) Application number: 22823889.5
(22) Date of filing: 14.04.2022
(51) Int. Cl.: H01L 27/32

(54) **DISPLAY PANEL AND DISPLAY DEVICE**

(30) Priority: 17.06.2021 CN 202121351741 U
(71) Applicant: ZTE Corporation, Shenzhen, Guangdong 518057 (CN)
(72) Inventor: ZHANG, Xiaoliang, Shenzhen, Guangdong 518057 (CN)
(74) Representative: Deambrogi, Edgardo
(86) International application number: PCT/CN2022/086883
(87) International publication number: WO 2022/262402

(57) **Abstract**

The present disclosure provides a display panel. The display panel includes a main pixel area and an auxiliary pixel area; the main pixel area is provided with a plurality of main pixel units; the auxiliary pixel area is provided with a plurality of auxiliary pixel units; the auxiliary pixel unit includes a transparent light-emitting element; and a pixel interval area is provided between two adjacent auxiliary pixel units. The display panel further includes a transparent dimming structure; the transparent dimming structure is provided on the back surface of the auxiliary pixel area; the transparent dimming structure includes a plurality of transparent dimming units; each transparent dimming unit corresponds to at least one auxiliary pixel unit; and the transparent dimming unit is configured to be capable of diffusing light transmitting through the transparent light-emitting element in the auxiliary pixel unit corresponding to the transparent dimming unit into the pixel interval area on the periphery of the auxiliary pixel unit. The present disclosure further provides a display device.

## Description

### Cross-reference of related applications

The present disclosure claims the priority of the Chinese patent application No. CN202121351741.6 filed on June 17, 2021 and entitled "display panel and display device", the entirety of which is incorporated herein by reference.

### Field of Technology

The present disclosure relates to the field of display device, and in particular, to a display panel and a display device including the display panel.

### Background

A display device has increasing functions, for example, a display device, such as a mobile phone, is usually provided with a front-facing camera. In order to improve visual effects, a high screen-to-body ratio is a trendy of the display device. In view of this, a concept of "full-screen" has been proposed in recent years, and full-screens of several types, such as a water drop screen and a notch screen, have emerged. The "water drop screen" refers to a screen in which a specialized water drop-shaped through hole is provided on a display panel and a front-facing camera is provided in the through hole. The "notch screen" refers to a screen in which a rectangular notch is provided on a display panel and a front-facing camera is provided in the rectangular notch. From this, neither the "water drop screen" nor the "notch screen" can realize the full-screen in essence.

### Summary

The present disclosure provides a display panel and a display device including the display panel.

In a first aspect of the present disclosure, a display panel is provided. The display panel includes a main pixel area and an auxiliary pixel area, the main pixel area is provided with a plurality of main pixel units, and the auxiliary pixel area is provided with a plurality of auxiliary pixel units. Each of the auxiliary pixel units includes a transparent light-emitting element, and a pixel interval area is provided between two adjacent auxiliary pixel units. The display panel further includes a transparent dimming structure. The transparent dimming structure is provided on a back surface of the auxiliary pixel area. The transparent dimming structure includes a plurality of transparent dimming units, and each of the transparent dimming unit corresponds to at least one auxiliary pixel unit. The transparent dimming unit is configured to be capable of diffusing light transmitting through the transparent light-emitting element in the auxiliary pixel unit corresponding to the transparent dimming unit into the pixel interval area on a periphery of the auxiliary pixel unit.

In some exemplary embodiments, the transparent dimming unit is further configured to be capable of collimating the light diffused into the pixel interval area on the periphery of the auxiliary pixel unit corresponding to the transparent dimming unit into parallel light.

In some exemplary embodiments, one transparent dimming unit corresponds to one auxiliary pixel unit.

In some exemplary embodiments, the transparent dimming unit include a concave lens and a convex lens opposite to the concave lens, the concave lens is provided on a surface of a corresponding auxiliary pixel unit and has a bottom surface edge located in the pixel interval area, the convex lens is opposite to the concave lens, and a gap is provided between the convex lens and the concave lens.

In some exemplary embodiments, the transparent dimming unit further includes a transparent spacer, and the transparent spacer is provided in the gap between the convex lens and the concave lens.

In some exemplary embodiments, an outer edge of an orthographic projection of the convex lens on the back surface of the auxiliary pixel unit overlaps with an edge of a bottom surface of the concave lens.

In some exemplary embodiments, a density of the main pixel units arranged in the main pixel area is greater than a density of the auxiliary pixel units arranged in the auxiliary pixel area.

In a second aspect of the present disclosure, a display device is provided. The display device includes a display panel and a camera, and the display panel is a display panel provided according to the first aspect of the present disclosure. The camera is provided on a back surface of the auxiliary pixel area and opposite to the transparent dimming structure.

In some exemplary embodiments, the display device further includes a polarizer, the polarizer includes a polarizer body and a through hole formed in the polarizer body, the polarizer is provided on a display surface of the display panel, and the through hole corresponds to the auxiliary pixel area.

In some exemplary embodiments, the display device further includes a light shield layer, the light shield layer includes a light shield layer body and a light transmitting hole formed in light shield layer body, and the light shield layer body is attached to a back surface of the display panel, and the light transmitting hole corresponds to the auxiliary pixel area, so that the transparent dimming structure is located in the light transmitting hole.

### Brief Description of the Drawings

FIG. 1 is a schematic top view of a display panel provided in the present disclosure;
FIG. 2 is a schematic diagram showing a plurality of pixel units by dividing a display panel via gate lines and data lines which cross to each other;
FIG. 3 is a schematic diagram of a principle for producing star-like local bright spots on an image when the image is formed by a front-facing camera;
FIG. 4 is a schematic diagram of a structure of a display device provided in the present disclosure;
FIG. 5 is a schematic diagram showing correspondence between an auxiliary pixel unit and a dimming structure;
FIG. 6 is a diagram showing a work principle of a dimming unit; and
FIG. 7 is a schematic exploded diagram of a structure of a dimming unit.

### Detailed Description of the Embodiments

In order to make a person skilled in the art better understand the technical solutions of the present disclosure, a display panel and a display device provided in the present disclosure will be described in detail below in conjunction with the drawings.

Hereinafter, exemplary embodiments will be more fully described in conjunction with the drawings, but the exemplary embodiments may be embodied in different forms and shall not be construed as being limited to the embodiments set forth herein. On the contrary, such embodiments are provided for the purpose of making the present disclosure thorough and complete and making a person skilled in the art fully to understand the scope of the present disclosure.

The embodiments in the present disclosure and the features in the embodiments may be mutually combined without conflict.

As used herein, the term "and/or" encompasses any or all combinations of one or more of the associated listed items.

The terms used herein are used only to describe particular embodiments and are not intended to limit the present disclosure. As used herein, the singular forms of "a" and "the" are also intended to include plural forms, unless otherwise the context clearly indicates. It is further to be understood that when the terms "including" and/or "made of ..." are used in the present disclosure, the presence of the features, wholes, steps, operations, components, and/or assemblies is specified, but the presence or addition of one or more other features, wholes, steps, operations, components, assemblies, and/or groups thereof is not excluded.

Unless otherwise defined, all the terms used herein (including technical and scientific terms) have the same meaning as commonly understood by those of ordinary skill in the art. It is further to be understood that the terms such as those defined in common dictionaries shall be construed as having meanings consistent with their meanings in the context of the related art and the present disclosure, and shall not be construed as having idealized or over-formal meanings, unless expressly defined in such a manner herein.

In order to realize "full-screen" in essence, pixel units may be provided in an area for a front-facing camera, rather than directly hollowing the area for the front-facing camera. It should be pointed out that, a light-emitting element in a pixel unit (for ease of description, the area corresponding to the front-facing camera is regarded as an auxiliary area) in the area for the front-facing camera should be a transparent light-emitting element with relatively high transparency, and external light may pass through the transparent light-emitting element and enters into the front-facing camera.

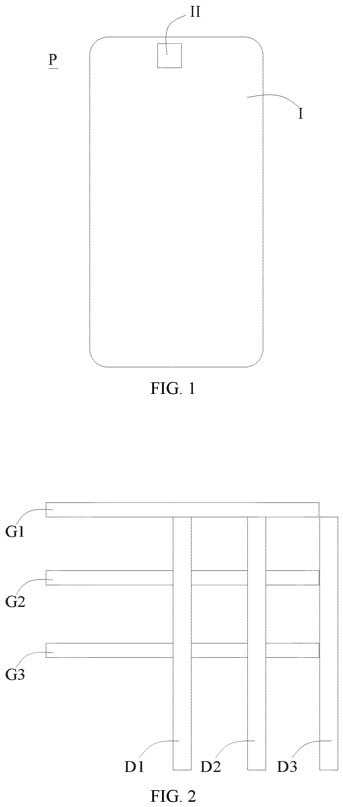

As shown in FIG. 2, a display panel includes gate lines (gate lines G1, G2, G3 as shown in FIG. 2) and data lines (data lines D1, D2, D3 as shown in FIG. 2) which are interlaced with each other, to provide an electrical signal for light-emitting elements. A conducting wire is usually made of a metal material for reducing resistance. The metal material has relatively poor light transmittance, so that the auxiliary area is equivalent to being divided into a plurality of light-emitting holes by the gate lines and the data lines.

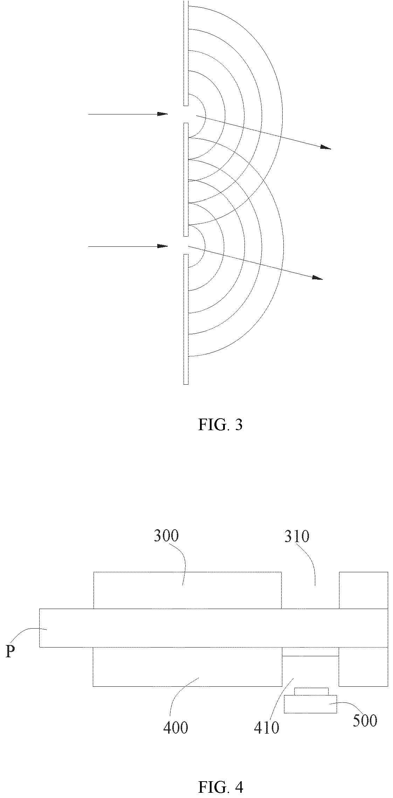

Due to diffraction of light, as shown in FIG. 3, a propagation direction of light rays passing through the light-emitting hole will be deflected. At the same time, after the light passes through the light-emitting hole (i.e., the light-emitting element), a diffraction field and an interference field will be formed due to interference of light, resulting in an area with a relatively high light intensity and an area with a relatively low light intensity on an imaging surface and eventually star-like local bright spots on an image acquired by the front-facing camera when the light rays reach the imaging surface of the front-facing camera.

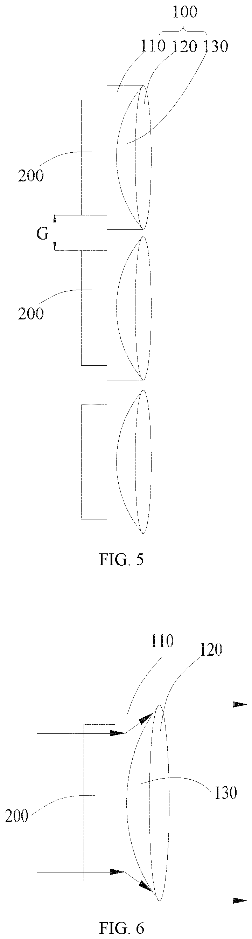

In order to solve the above problems, in a first aspect of the present disclosure, a display panel is provided. As shown in FIG. 1 and FIG. 4, the display panel P includes a main pixel area I and an auxiliary pixel area II. The main pixel area I is provided with a plurality of main pixel units, and the auxiliary pixel area II is provided with a plurality of auxiliary pixel units. As shown in FIG. 5, an auxiliary pixel unit includes a transparent light-emitting element 200, and a pixel interval area G is provided between two adjacent auxiliary pixel units 200. As shown in FIG. 4 and FIG. 5, the display panel further includes a transparent dimming structure, and the transparent dimming structure is provided on a back surface of the auxiliary pixel area II. As shown in FIG. 5, the transparent dimming structure includes a plurality of transparent dimming units 100, and each of the transparent dimming units 100 corresponds to at least one auxiliary pixel unit. The transparent dimming unit 100 can diffuse light transmitting through the transparent light-emitting element 200 in the auxiliary pixel unit corresponding to the transparent dimming unit 100 into the pixel interval area G on a periphery of the auxiliary pixel unit 200.

It should be pointed out that, in the present disclosure, a surface of the display panel for displaying an image for viewing by a viewer is referred to a display surface, and a surface opposite to the display surface is referred to a back surface. Signal lines such as gate lines and data lines are provided in the pixel interval area G. The light transmitting through the transparent light-emitting element 100 in the auxiliary pixel unit is the light required for imaging by an under-screen camera provided in the display device (such light at least includes ambient light, and light reflected by a to-be-imaged object). After the transparent dimming unit is provided, the light transmitting through the transparent light-emitting element 100 in the auxiliary pixel units is diffused into the pixel interval area G, which may at least reduce the diffraction of light and the interference of light in a certain extent and thus may at least reduce the star-like local bright spots on the image acquired by the front-facing camera in a certain extent.

In the present disclosure, there is no particular limitation on how the transparent dimming unit 100 diffuses the light transmitting through the transparent light-emitting element in the auxiliary pixel unit corresponding to the transparent dimming unit into the pixel interval area on the periphery of the auxiliary pixel unit.

As an exemplary implementation, the transparent dimming unit 100 may include a concave lens with a gradual increasing in thickness from a middle to an edge.

As another exemplary implementation, the transparent dimming unit 100 may include an equivalent concave lens with a uniform thickness. The following introduces the realization of the above equivalent concave lens. The equivalent concave lenses in the display panel are provided in an array, and equivalent convex lenses in the display panel are provided in an array. The display panel may include a first liquid crystal control panel. The first liquid crystal control panel includes a plurality of first lens units, and the equivalent concave lens with a first predetermined focal length may be obtained by controlling a deflection angle of liquid crystal molecules in the first lens unit.

In addition, the equivalent concave lens with a concave lens effect may alternatively be realized by setting a refractive index of a plate-like light transmitting material with a uniform thickness at different areas.

In some exemplary embodiments, in order to make the brightness of the light rays reaching a photosurface of the front-facing camera more uniform, the transparent dimming unit 100 may further be configured to be capable of collimating the light diffused into the pixel interval area on the periphery of the auxiliary pixel unit corresponding to the transparent dimming unit 100 into parallel light.

In the present disclosure, there is no particular limitation on the number of the auxiliary pixel units corresponding to each transparent dimming unit. In order to achieve a good dimming, in some exemplary embodiments, one transparent dimming unit corresponds to one auxiliary pixel unit. In other words, the light transmitting through the transparent light-emitting element in each auxiliary pixel unit can be adjusted, so that light reaching a lighting surface of the front-facing camera may be more uniform.

In the present disclosure, there is no particular limitation on a structure of the transparent dimming unit 100, as long as the light transmitting the corresponding transparent light-emitting element can be adjusted into the pixel interval area and collimated.

As an exemplary implementation, as shown in FIG. 5, the transparent dimming unit 100 may include a concave lens 110 and a convex lens 120 opposite to the concave lens 110, the concave lens 110 is provided on a back surface of a corresponding auxiliary pixel unit and has a bottom surface edge located in the pixel interval area G, the convex lens 120 is opposite to the concave lens 110, and there is a gap between the convex lens 120 and the concave lens 110.

As shown in FIG. 6, the convex lens 110 may diverge the light rays. The light transmitting through the transparent light-emitting element 200 may be further diffused by the concave lens 110 and then reaches the pixel interval area G. The light diffused by the concave lens 110 is transferred to the convex lens 120 and may be collimated into the parallel light by the convex lens 120. It should be pointed out that at least part of the light transmitting through the concave lens 110 is propagated in the gap and then enters the convex lens 120.

In the present disclosure, there is no particular limitation on a size of the concave lens 110, the convex lens 120 and the gap, as long as the convex lens 110 can diffuse the incident light rays into the pixel interval area, and the convex lens 120 collimates the light diffused by the convex lens into the parallel light.

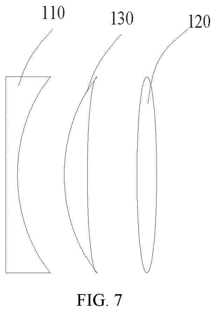

For ease of machining and manufacturing, as an exemplary implementation, as shown in FIG. 6 and FIG. 7, the transparent dimming unit 100 further includes a transparent spacer 130 in the gap between the convex lens 120 and the concave lens 110.

It should be pointed out that the convex lens 120 and the concave lens 110 may be made of a material with a relatively high refractive index, and the transparent spacer 130 may be made of a material with a relatively low refractive index.

For ease of machining and manufacturing, as an exemplary implementation, an outer edge of an orthographic projection of the convex lens 120 on the back surface of auxiliary pixel unit overlaps with an edge of a bottom surface of the concave lens 110.

In the present disclosure, side walls of two adjacent transparent dimming units 100 may be attached to each other. Moreover, as an exemplary implementation, the bottom surface edge of the concave lens 110 is located on a midline in width of a corresponding pixel interval area.

In the present disclosure, the transparent dimming unit 100 may be formed by various methods, such as transfer print and ink-jet printing.

As described above, an equivalent concave lens may be realized by the first liquid crystal control panel. Similarly, an equivalent convex lens may be formed by a second liquid crystal control panel. In an exemplary embodiment, the plurality of equivalent convex lenses in the display panel are arranged in an array. The second liquid crystal control panel includes a plurality of second lens units, and the equivalent convex lens with a second predetermined focal length may be obtained by controlling a deflection degree of liquid crystal molecules in the second lens units.

In addition, the equivalent convex lens with a convex lens effect may further be realized by setting a refractive index of a plate-like light transmitting material with a uniform thickness at different areas.

In the present disclosure, there is no particular limitation on the form of the main pixel area in the display panel. It should be pointed out that the main pixel area mainly acts to display an image. In order to improve light transmittance, the auxiliary pixel unit in the auxiliary pixel area needs to have a relatively large opening area, so as to reduce a density of the auxiliary pixel units in the auxiliary pixel area. In order to improve a display effect, the main pixel area needs to have a relatively high pixel density. In other words, the number of the main pixel units per unit area of the main pixel area needs to be greater than the number of the auxiliary pixel units per unit area of the auxiliary pixel area.

As an exemplary implementation, the light transmittance of a material for making the light-emitting element in the main pixel unit may be lower than the light transmittance of a material for making the transparent light-emitting element in the auxiliary pixel unit.

In order to further reduce non-uniform brightness distribution of the lighting surface of the front-facing camera due to light diffraction and light interference, in some exemplary embodiments, a transparent conductive material (e.g., indium tin oxide) may be used for making the signal lines in the pixel interval area.

As an exemplary implementation, the display panel may be an AMOLED display panel.

In a second aspect of the present disclosure, a display device is provided. As shown in FIG. 4, the display device includes a display panel P and a camera 500. The display panel is the above panel provided in the first aspect of the present disclosure, and the camera 400 is provided on the back surface of the auxiliary pixel area II and opposite to the transparent dimming structure 100.

As described above, since the transparent dimming structure 100 is provided, the diffraction of light and the interference of light are reduced or even eliminated, and the brightness of the light irradiating on the lighting surface of the camera 100 is uniform, which may improve an imaging effect.

In order to improve the display effect of the display device, as shown in FIG. 4, the display panel may further include a polarizer, the polarizer includes a polarizer body 300 and a through hole 310 formed in polarizer body 300, the polarizer is provided on a display surface of the display panel P, and the through hole 310 corresponds to the auxiliary pixel area II.

In order to further improve the display effect, as shown in FIG. 4, the display device may further include a light shield layer, and the light shield layer includes a light shield layer body 400 and a light transmitting hole 410 formed in the light shield layer body. The light shield layer body 400 is attached to a back surface of the display panel P, and the light transmitting hole 410 corresponds to the auxiliary pixel area II, so that the transparent dimming structure 100 is located in the light transmitting hole 410.

In the present disclosure, there is no particular limitation on a structure of the light shield layer body 400. As an exemplary implementation, the light shield layer body 400 may be made of foam.

In the present disclosure, there is no particular limitation on a structure of the display device. The display device may be an electronic device, such as a mobile phone, a tablet computer and the like.

In the display panel provided in the present disclosure, full-screen display may be realized in essence by providing the transparent light-emitting element in the auxiliary pixel area. Moreover, in the present disclosure, after the transparent dimming unit corresponding the auxiliary pixel area is provided, the light transmitting through the transparent light-emitting element in the auxiliary pixel unit is diffused into the pixel interval area, so that the diffraction of light and the interference of light may be at least reduced in a certain extent, and thus the star-like local bright spots on the image acquired by the front-facing camera of the display device may be at least reduced in a certain extent, thereby improving the imaging effect.

The above embodiments only have general illustrative meanings and are not used for a restrictive purpose. In some embodiments, it is obvious to a person skilled in the art that features, characteristics and/or elements described in combination with a specific embodiment may be used alone, or may be used in combination with features, characteristics and/or elements described in combination with other embodiments, unless otherwise stated expressly. Accordingly, it will be understood by a person skilled in the art that various changes in form and detail may be made without departing from the scope of the present disclosure as set forth in the appended claims.

## Claims

1. A display panel, comprising a main pixel area and an auxiliary pixel area, the main pixel area being provided with a plurality of main pixel units, and the auxiliary pixel area being provided with a plurality of auxiliary pixel units, wherein
each of the auxiliary pixel units comprises a transparent light-emitting element, and a pixel interval area is provided between two adjacent auxiliary pixel units;
the display panel further comprises a transparent dimming structure, the transparent dimming structure is provided on a back surface of the auxiliary pixel area;
the transparent dimming structure comprises a plurality of transparent dimming units, and each of the transparent dimming units corresponds to at least one auxiliary pixel unit; and
each of the transparent dimming units is configured to be capable of diffusing light a transmitting through the transparent light-emitting element in an auxiliary pixel unit corresponding to the transparent dimming unit into the pixel interval area on a periphery of the auxiliary pixel unit.

2. The display panel according to claim 1, wherein
each of the transparent dimming units is further configured to be capable of collimating the light diffused into the pixel interval area on the periphery of the auxiliary pixel unit corresponding to the transparent dimming unit into a parallel light.

3. The display panel according to claim 2, wherein
one transparent dimming unit corresponds to one auxiliary pixel unit.

4. The display panel according to claim 3, wherein
each of the transparent dimming units comprises a concave lens and a convex lens opposite to the concave lens, the concave lens is provided on the back surface of a corresponding auxiliary pixel unit, and the concave lens has a bottom surface edge located in the pixel interval area, the convex lens is opposite to the concave lens, and a gap is provided between the convex lens and the concave lens.

5. The display panel according to claim 4, wherein
each of the transparent dimming units further comprises a transparent spacer, and the transparent spacer is provided in the gap between the convex lens and the concave lens.

6. The display panel according to claim 4, wherein
an outer edge of an orthographic projection of the convex lens on the back surface of the auxiliary pixel unit overlaps with the bottom surface of the concave lens.

7. The display panel according to any one of claims 1 to 6, wherein
a density of the main pixel units arranged in the main pixel area is greater than a density of the auxiliary pixel units arranged in the auxiliary pixel area.

8. A display device, comprising a display panel and a camera, wherein
the display panel is a display panel according to any one of claims 1 to 7, and the camera is provided on a back surface of the auxiliary pixel area and opposite to the transparent dimming structure.

9. The display device according to claim 8, further comprising a polarizer, wherein
the polarizer comprises a polarizer body and a through hole formed in the polarizer body, the polarizer is provided on a display surface of the display panel, and the through hole corresponds to the auxiliary pixel area.

10. The display device according to claim 8 or 9, further comprising a light shield layer, wherein
the light shield layer comprises a light shield layer body and a light transmitting hole formed in the light shield layer body, the light shield layer body is attached to a back surface of the display panel, and the light transmitting hole corresponds to the auxiliary pixel area, so that the transparent dimming structure is located in the light transmitting hole.
